# EUROPEAN PATENT APPLICATION

(11) **EP 1 447 845 A2**
(43) Date of publication of application: **18.08.2004**
(21) Application number: 04002622.1
(22) Date of filing: 06.02.2004
(51) Int. Cl.: H01L 23/31

(54) **Package of electronic components and method for producing the same**

(30) Priority: 12.02.2003 JP 2003034274
(71) Applicant: MATSUSHITA ELECTRIC INDUSTRIAL CO., LTD., Kadoma-shi, Osaka 571-8501 (JP)
(72) Inventor: Higashitani, Hideki, Souaaku-gun Kyoto 619-0225 (JP)
(74) Representative: Stippl, Hubert, Dipl.-Ing.

(57) **Abstract**

An electronic component package (106) includes: at least one electronic component (101); a wiring provided with a terminal portion (102) with which the electronic component (101) is connected electrically; and a resin portion (105) that covers at least a part of the electronic component (101) and is for bonding the wiring. A part of the wiring extends by way of an edge of the package (106) so as to be formed on a surface and a rear face of the package. With this configuration, wirings can be formed freely on the surface of the package without using a flexible board, and input and output terminals (102, 104) from the electronic component can be arranged on the surface and the rear face of the package.

## Description

The present invention relates to a package in which electronic components are packaged densely and a method for producing the same.

In resent years, a demand for smaller and thinner mobile equipment has been escalated, and, as represented by mobile phones, more functions are incorporated into the same size so as to create a definite distinction between various devices. In order to fulfill this demand, various technologies have been developed, and also as for configurations for mounting electronic components, many contrivances have been made for building up and arranging electronic components three-dimensionally so as to reduce a footprint of the electronic components.

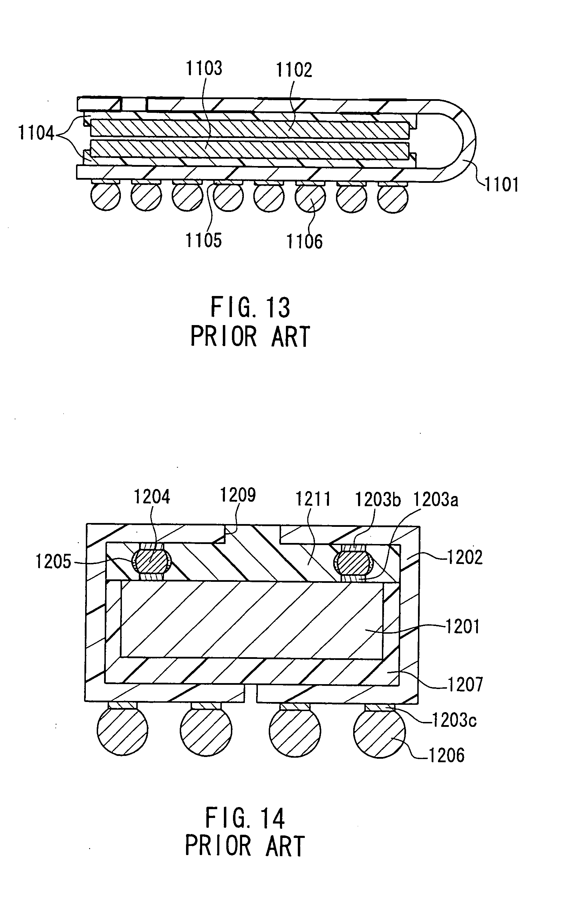

As such a package in which electronic components are built up and arranged, one proposal is that a semiconductor element is mounted on a flexible board and then the flexible board is folded. Fig. 13 shows an example where semiconductor elements are built up and mounted by bare-chip mounting a plurality of semiconductor elements on a flexible board, followed by the folding of the flexible board.

The following is a brief description on the conventional example, with reference to Fig. 13. Semiconductor elements 1102 and 1103 are bare-chip mounted on a flexible board 1101. As for a method for the mounting, there are various methods such as wire bonding, ACF (Anisotropic Conductive Film), NCF (Non conductive Film) and solder, and in terms of the miniaturization of a package, these elements often are bare-chip mounted in a face-down manner using the ACF, NCF, solder and the like. During this mounting, an encapsulating resin 1104 is provided between the semiconductor elements and the flexible board for the purpose of reinforcing the mounting strength of the bare chip and securing mounting reliability. This package is configured by folding it so that the semiconductor elements overlap one another, and an external connection terminal 1105 is provided on the outside of the package. On this external connection terminal, a solder ball 1106 is mounted, through which the electrical connection is established with a main board. In this way, the flexible board with the semiconductor elements mounted thereon is folded, whereby a footprint of the semiconductor elements can be reduced. Such a conventional three-dimensional semiconductor device may include a large number of semiconductor elements mounted thereon (See for example JP 2001-168272A).

As another proposal, as shown in Fig. 14, a semiconductor element 1201 is mounted via a bump 1204 on a flexible printed circuit (FPC) 1202 provided with a solder ball 1206, followed by the folding of the FPC 1202, which is then attached to a periphery of the semiconductor element 1201 with an adhesive sheet 1207. Then, a resin 1211 is filled into a gap therebetween, followed by curing so as to form a semiconductor package (See for example JP H08-97312 A). In Fig. 14, reference numerals 1203a, 1203b and 1203c denote pads, 1205 denotes a conductive substance and 1209 denotes a hole for encapsulating resin.

With a recent trend toward further higher-density equipment, however, a still smaller and thinner package of an electronic component is now demanded. According to the conventional technologies, since electronic components such as semiconductor elements are mounted on a flexible board and the flexible board is folded, a curvature radius cannot be reduced because of a restriction due to the thickness of the flexible board. As a result, the thickness of the package is increased. Additionally, since an expensive flexible board is used irrespective of a density of wirings to be accommodated, the cost of a package inevitably increases.

Therefore, with the foregoing in mind, it is an object of the present invention to provide an electronic component package at a low cost that is made thinner by configuring the package with external connection terminals on a surface and a rear face of the package and to provide an electronic component package in which electronic components can be built up and mounted densely and with low-profile and a method for manufacturing the same.

An electronic component package of the present invention includes: at least one electronic component; a wiring provided with a terminal portion with which the electronic component is connected electrically; and a resin portion that covers at least a part of the electronic component and is for bonding the wiring. In this package, a part of the wiring on a surface of the package extends by way of an edge of the package so as to be formed on a surface and a rear face of the package.

A method for manufacturing an electronic component package of the present invention includes the steps of forming a wiring on a supporting member; mounting an electronic component to a terminal portion formed in the wiring layer; folding the supporting member with the wiring formed thereon so that the supporting member covers at least a part of the electronic component, while forming a resin portion in a space between the supporting member and the electronic component; bonding the wiring so as to assemble the package; and removing the supporting member.

Another electronic component package of the present invention includes: at least one electronic component; and a metal wiring that is connected to the electronic component electrically. The electronic component and at least one face of the metal wiring are bonded to a resin so as to be integrated. In this package, a roughness of the metal wiring is larger at an outer surface than at a bonding face, and a convex and concave structure of the outer surface is formed by metal particles.
Fig. 1A is a cross-sectional view showing a configuration of an electronic component package of Embodiment 1 of the present invention, Fig. 1B shows the appearance of the package that is viewed from the upper face and Fig. 1C shows the appearance of the package that is viewed from the lower face.
Fig. 2A is a cross-sectional view showing another electronic component package of Embodiment 1 of the present invention, and Fig. 2B is a cross-sectional view showing the package.
Fig. 3A is a cross-sectional view showing still another electronic component package of Embodiment 1 of the present invention, and Fig. 3B is a cross-sectional view showing a state where bare-chip mounting is conducted on the package.
Fig. 4A is a cross-sectional view showing a further electronic component package of Embodiment 1 of the present invention, and Fig. 4B is a plan view of the package.
Fig. 5A is a cross-sectional view showing a still further electronic component package of Embodiment 1 of the present invention, and Fig. 5B is a cross-sectional view of the package.
Fig. 6A is a cross-sectional view showing a configuration of another electronic component package of Embodiment 1 of the present invention, and Fig. 6B is a cross-sectional view of the package.
Figs. 7A to E are cross-sectional views showing each of the main manufacturing steps of the electronic component package in Embodiment 1 of the present invention.
Figs. 8A to F are cross-sectional views showing each of the main manufacturing steps of another electronic component package in Embodiment 1 of the present invention.
Figs. 9A to C are cross-sectional views showing each of the main manufacturing steps of the wiring transfer matrix in Embodiment 1 of the present invention, Fig. 9D is a partially enlarged view of Fig. 9A at the X portion, and Fig. 9E is a partially enlarged view of Fig. 9B at the Y portion.
Figs. 10A to B are cross-sectional views showing each of the main manufacturing steps of another wiring transfer matrix in Embodiment 1 of the present invention.
Fig. 11 is a cross-sectional view showing a configuration of an electronic component package of Embodiment 2 of the present invention.
Figs. 12A to D are cross-sectional views showing each of the main manufacturing steps of the electronic component package in Embodiment 2 of the present invention.
Fig. 13 is a cross-sectional view showing a conventional built-up package of a semiconductor element.
Fig. 14 is a cross-sectional view showing a conventional built-up semiconductor package.
Fig. 15A is a cross-sectional view showing an electronic component package of Embodiment 3 of the present invention, Fig. 15B is a plan view of the package that is viewed from a side of the external connection terminals, and Fig. 15C is an enlarged cross-sectional view of the external connection terminal of Fig. 15A at the X portion.
Fig. 16 is a cross-sectional view showing an example where a solder resist is formed on a surface of the electronic component package of Embodiment 3 of the present invention.
Figs. 17A to E are cross-sectional views of the process showing a manufacturing method of Embodiment 3 of the present invention.
Fig. 18 is an enlarged cross-sectional view of the Y portion of Fig. 17A.

According to the electronic component package of the present invention, wirings can be formed freely on the surface of the package, and input and output terminals from the electronic components can be arranged on the surface and the rear face of the package. That is to say, the wirings are formed with respect to the electronic components only by way of the resin portion, and therefore the electronic component package can be made slimmer and at the same time electronic components can be mounted further on the package, thus enabling the high-density and low-profile building up and mounting of electronic components.

In the present invention, an "electronic component package" refers to a structure in which one ore more electronic components are mounted on a structure (board or the like) to which wiring is provided. A "wiring" refers to means for conveying electrical signals, and normally is made up of metal. ''Electronic components" is a generic name referring to active elements (semiconductor elements, semiconductor packages, quartz resonators, surface acoustic wave (SAW) filters and the like) and passive elements (resistors, inductors, capacitors and the like). "Chip components" refer to minute components whose size is specified as 1005, 0603 and the like, which are found in passive element components such as resistors, inductors and capacitors. "Semiconductor elements" refer to semiconductors that have not been packaged. In the case of bare-chip mounting, semiconductor elements are mounted on a board. A semiconductor package is obtained by packaging (QFP, BGA, CSP and the like) semiconductor elements.

Preferably, the above-described electronic component package further includes external connection terminals on the surface and the rear face of the package. The formation of the external connection terminals on both faces of the package facilitates the building up and mounting of low-profile electronic component packages together. As for the electronic component packages, non-defective products can be selected beforehand by conducting an electrical test on individual pieces, thus enabling the building up of non-defective packages only. As a result, the yield of the assembly can be improved.

In the above-described electronic component package, it is preferable that the electronic component is a semiconductor element that is bare-chip mounted in a face-down manner with respect to the wiring. As for the semiconductor element, a technology of making a slim semiconductor element of not more than about 50 µm thickness is proposed currently. Wirings are formed on a surface and a rear face of such a semiconductor element and connection terminals are provided thereon, whereby a very thin semiconductor package can be provided at a low cost.

In the above-described electronic component package, it is preferable that the electronic component is a semiconductor element, and a terminal portion of the semiconductor element exposed from the resin portion is connected electrically with the terminal portion of the wiring by wire bonding. This embodiment allows electrical signals to be carried from the active face of the semiconductor element to the rear face only by way of the resin portion, whereby a low-profile semiconductor package can be provided even when bare-chip mounting is employed, using a versatile wire bonding.

In the above-described electronic component package, it is preferable that the electronic component is a semiconductor element, and a plurality of the semiconductor elements are built up and arranged within the package. According to this embodiment, the semiconductor elements are built up within the package, so that a low-profile package in which functions are modularized with a plurality of semiconductor elements can be provided.

In the above-described electronic component package, it is preferable that the electronic component includes at least one passive component that is selected from the group consisting of a resistor, a capacitor and an inductor. According to this embodiment, a wider range of electrical circuits can be formed within the package as a functional module. Furthermore, when a low-profile electronic component package with a capacitor built therein is used as an interposer for the semiconductor element, a power source for the semiconductor element can be stabilized with the thin interposer board, thus realizing a high-speed operation by the semiconductor element.

In the above-described electronic component package, it is preferable that the wiring is embedded in the resin portion. The configuration of the wiring being embedded in the resin portion can enhance the adhesive strength at the external connection terminal portion, resulting in the enhancement of the mounting reliability. In addition, since the wiring is embedded, there are no problems occurring such that the wiring being bent and disconnected due to an external force applied during the handling, even for a fine wiring portion with a wiring width of about 25 µm.

In the above-described electronic component package, it is preferable that the resin portion provided in the package includes different materials that are built up within the package in a direction of a thickness of the package. With respect to the external connection terminals that are formed on the surface of the package, different loads may be generated depending on physical properties such as the rigidity and the thermal expansion coefficient of the member that is connected therewith. Then, a material with a low elastic modulus may be employed at a portion connected with a member having a substantially different thermal expansion coefficient from that of the semiconductor element so that the resin functions as an elastomer, whereby the mounting reliability of the external connection terminal portions can be enhanced.

It is preferable to configure a built-up electronic components package by building up any of the above-described electronic component packages. In this way, by building up and mounting low-profile electronic component packages, a low-profile functional module can be formed by combining non-defective packages that are selected by electrical testing, resulting in the provision of a low-profile and high-density package of electronic components with high yields.

According to the manufacturing method of the present invention, wirings can be formed on a surface and a rear face of the electronic component and a low-profile electronic component package can be provided. At the same time, an electronic component package provided with external connection terminals on the surface and the rear surface thereof can be provided at a low cost and electronic components can be built up and mounted densely and with a low-profile.

In the above-described method for manufacturing an electronic component package, it is preferable that the supporting member is formed with resin, the wiring is held onto the supporting member with a plurality of convex and concave shapes that are provided at an interface between the wiring and the supporting member, and in the step of removing the supporting member, the supporting member is peeled off mechanically. According to this embodiment, an excellent flexibility is obtained because the supporting member is formed with resin, and therefore the folding can be conducted easily in the assembly step. In addition, since the supporting member can be peeled off mechanically after the assembly, the package of the present invention can be manufactured by a method with a high productivity

In the above-described method for manufacturing an electronic component package, it is preferable that the supporting member is formed with metal, and in the step of removing the supporting member, the supporting member is dissolved with a chemical agent for the removal. According to this embodiment, when the supporting member is to be removed, it can be removed by dissolving with the chemical agent, and therefore the package can be manufactured without applying a mechanical stress to the package. At the same time, the supporting member can be removed using a simple manufacturing apparatus for immersing the supporting member in the chemical agent.

According to the present invention, wirings can be formed freely on the surface of the package, and input and output terminals from the electronic components can be arranged on the surface and the rear face of the package. That is to say, the wirings are formed with respect to the electronic components only by way of the resin portion, and therefore the electronic component package can be made slimmer and at the same time further electronic components can be mounted on the package at a low cost, thus enabling the high-density and low-profile building up and mounting of electronic components.

In addition, when a conductor such as solder is connected to the surface of the package, a solder resist is generally formed on the surface of the package so as to suppress the spreading of the molten solder. According to the package of the present invention, a convex and concave configuration formed with metal particles is formed on the surface of a wiring material, which can enhance the adhesion properties of the wiring material and the solder resist. As a result, delamination occurring between the solder resist and the wiring from a mechanical stress due to thermal shock and the like can be suppressed. Note here that the convex and concave configuration may be formed on a surface of the resin.

In another electronic component package of the present invention, a roughness of the metal wiring may be larger at an outer surface than at a bonding face, and a convex and concave of the outer surface may be formed by metal particles. With this configuration, when a conductor is connected to the outside of the metal wiring, the connection can be established firmly. It is preferable that a ten point height of irregularities (Rz) of an outer surface of the metal wiring ranges from 0.1 µm to 4 µm, inclusive. This range of roughness allows the firmer connection when a conductor is connected to the outside of the metal wiring. Note here that the ten point height of irregularities (Rz) is determined as follows: in an extracted portion of a cross-sectional curve with a referential length, an average value of the heights of the highest to the fifth highest peaks and an average value of the depths of the deepest to the fifth deepest bottoms are determined. Then, Rz is obtained from determining a difference between these average values, which is represented with µm (JIS B 0601).

It is preferable that the metal wiring is formed by transferring. When the metal wiring is formed by transferring and not by etching, the test of the wiring can be conducted prior to the transferring, which results in the wiring formation with high yields because only non-defective wirings can be formed on the surface of the package.

A pattern transferred from a convex and concave on the outer surface of the metal wiring may be formed at a resin face of the package that is on the periphery of the metal wiring. When the metal wiring is formed by the transferring method, a surface shape of the transfer sheet may be provided on the resin face as a replica. In this case, by further providing the transferred pattern portion as a convex and concave configuration on the resin face with resin, an adhesion strength for bonding with a board or the like can be increased.

The electronic component may be a semiconductor element that is bare-chip mounted in a face-down manner with respect to the wiring. In addition, the electronic component may be a semiconductor element, and a terminal portion of the semiconductor element exposed from the resin portion may be connected electrically with a terminal portion of the wiring by wire bonding. Furthermore, the electronic component may be a semiconductor element, and the semiconductor element may be built up and arranged within the package. Moreover, the electronic component may include at least one passive component that is selected from the group consisting of a resistor, a capacitor and an inductor. Furthermore, the wiring may be embedded in the resin portion. Moreover, a plurality of layers of the packages may be formed.

The following describes embodiments of the present invention, with reference to the drawings. In the following description, the same reference numerals denote the same elements.

### Embodiment 1

Referring now to the drawings, one embodiment of the present invention will be described below.

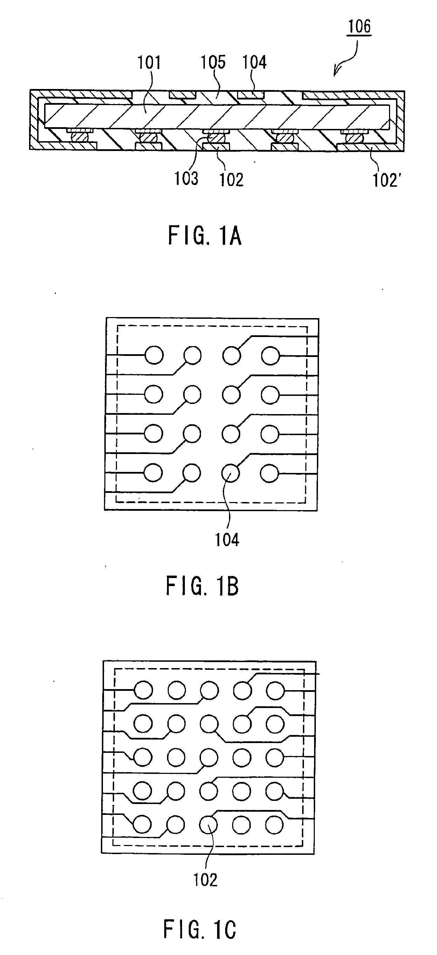

Figs. 1A to C show a configuration of a package of an electronic component according to this embodiment. Fig. 1A is a cross-sectional view showing a configuration of a package 106. As the electronic component, a semiconductor element 101 is bare-chip mounted in a face-down manner to an external connection terminal 102 that is formed as a wiring layer. Although this drawing shows the case where a connection terminal for the bare-chip mounting doubles as the external connection terminal, these terminals may be provided separately so as to avoid direct application of a mounting stress, which occurs during the mounting to a mother board to a bare-chip connection portion. Although Fig. 1A shows an example where the semiconductor element 101 is mounted by means of a solder 103, a method for mounting the semiconductor element is not limited to this, and similar effects can be obtained also by using ACF (Anisotropic Conductive Film), Au-Au bonding, stud bump bonding in which an Au bump and a conductive paste are combined, and the like. The wiring layer is led out to a rear-face side of the semiconductor element along the semiconductor element 101 at an edge of the package 106 so as to form an external connection terminal 104 also on the rear-face side of the semiconductor element. This wiring layer is bonded and held to the semiconductor element by a resin portion 105. Additionally, this resin portion 105 has a function for protecting mechanically an electrical connecting portion between the semiconductor element and the connection terminal.

A wiring 102' on a surface (that is the same as the external connection terminal 102) is formed on the surface and the rear face of the package 106 by way of the edge of the package 106. The external connection terminal 102 and the wiring 102' are made of metal such as copper, and therefore they are directly connected to the semiconductor element 101 via the solder 103.

When the conventional flexible printed circuit (FPC) is used so as to mount an electronic component thereon, followed by the folding of the flexible wiring board and the formation of external connection terminals of the package on a rear-face of the electronic component, in order for a wiring of the flexible wiring board led out from a mounting face of the electronic component to be exposed to the surface of the package as an external connection terminal, a through hole needs to be provided in the flexible wiring board. Thus, the wiring may be routed electrically to the rear-face side of the flexible wiring board via this through hole.

That is to say, in order to form the connection terminal of the electronic component on the rear face of the electronic component, an expensive double-sided flexible wiring board needs to be used. In addition, as for the above-described through hole that is provided in the flexible wiring board, in general, an inner wall of the through hole is connected by plating, which becomes a restriction for arranging a wiring. Such restriction increases with the number of through holes, resulting in the difficulty in increasing a wiring density on the flexible wiring board.

According to the package of the present invention, however, the wiring can be formed directly on the surface of the package, and therefore the surface and the rear face of the wiring can be used for electrical connection. That is, when the external connection terminal of the package is led out to the rear face, a desired wiring can be formed with one wiring layer that is actually required. In other words, without using an expensive double-sided flexible wiring board that is required for the above-described conventional example, a package can be formed by a manufacturing method at a low cost.

Fig. 1B is a plan view of the package that is viewed from a side of the external connection terminal 104, and Fig. 1C shows a rear face of the package on a side of the external connection terminal 102. Some of the external connection terminals on the surface and the rear face of the package are connected electrically by way of the edge of the package. Although these drawings show an example where the wirings are led out to the rear-face side by way of two edges of the package, the leading-out of the wirings is not limited to this example, and the way of the leading-out may be selected from one to four edges depending on the wiring design.

Although not illustrated in Fig. 1 A, it is preferable that a solder resist is formed on the surface of the external connection terminals that are formed on the surface and the rear face of the package, because this configuration can suppress a short between the wirings when the connection with the outside of the package is established using solder.

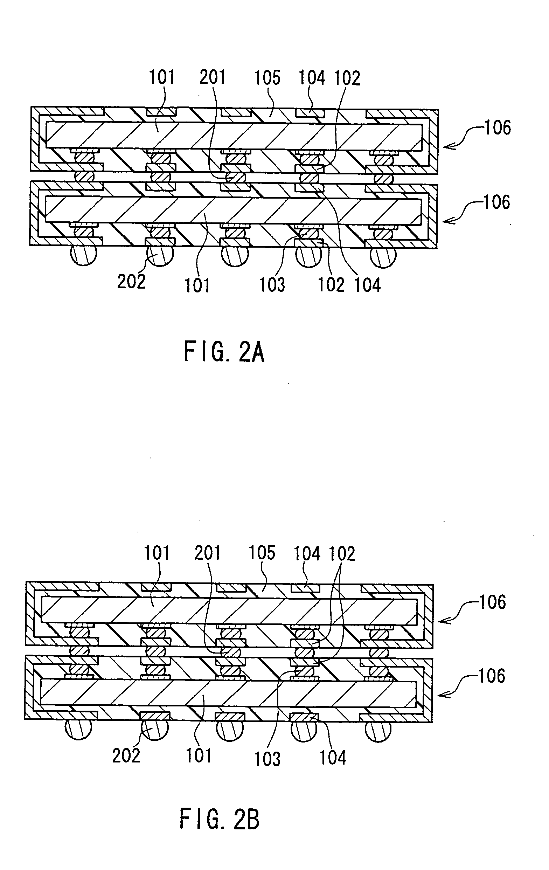

The following describes a built-up structure of an electronic component package according to this embodiment, with reference to Figs. 2A to 2B. Fig. 2A shows an example where the electronic component packages 106 and 106 shown in Fig. 1 are built up and mounted using solder 201. Since the electronic component package 106 of this embodiment is provided with the external connection terminals 102 and 104 on the surface and the rear face of the package, the packages can be built up by a simple method as shown in Fig. 2A. Furthermore, since the package does not employ a flexible board and is provided with the wirings that are formed directly on the electronic component such as a semiconductor element via a resin portion, a low-profile package can be realized. As a result, when the packages are built up, the thickness can be reduced. Such a configuration of the electronic component package allows the selection of non-defective products by conducting electrical test beforehand in the individual state, thus enabling the building up of non-defective packages only. As a result, the yield of the assembly can be improved.

Alternatively, as shown in Fig. 2B, the building-up may be carried out so that mounting faces of semiconductor elements that are arranged within the package are opposed to each other. Such building-up allows the electrical connection within a short distance between the semiconductor elements 101 and 101 via external connection terminals 102 and 104. This enables the secure operation of the semiconductor elements even in the case of electrical signals with high speed and high frequencies. Additionally, as shown in Fig. 2B, an external connection terminal 202 that is connected with a mother board may be made different from the connection terminal 201 with the semiconductor elements, which can suppress a deterioration of connection reliability of a mounting portion of the semiconductor elements due to the mounting stress that occurs when the package is mounted to the mother board.

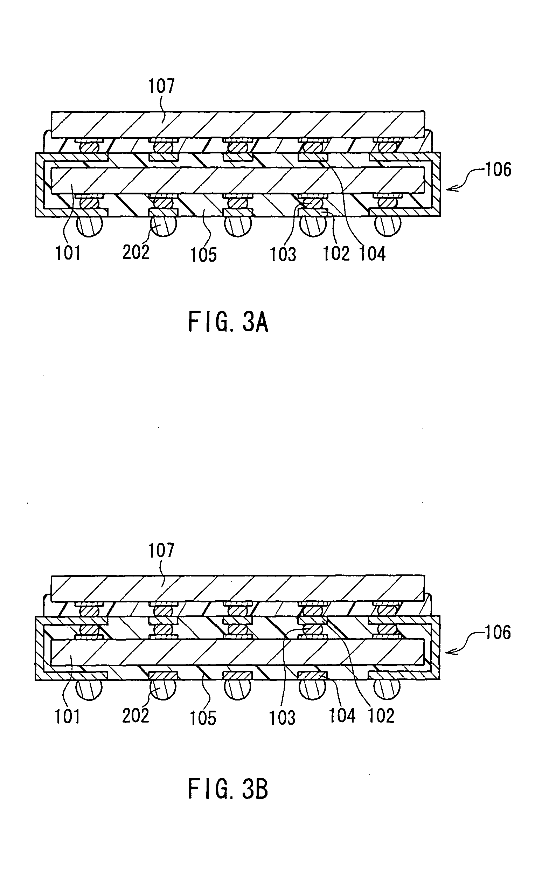

Furthermore, as shown in Fig. 3A, a semiconductor element 107 may be bare-chip mounted directly on the electronic component package 106 of this embodiment. In the case where the number of semiconductor elements to be built up is limited to two, the bare-chip mounting of the semiconductor element 107 on the electronic component package 106 of this embodiment also can realize a low-profile built up semiconductor package.

Also as for such a mounting configuration, as shown in Fig. 3B, mounting faces of semiconductor elements may be opposed to each other and an external connection terminal that is connected with a mother board may be made different from a connection terminal with the semiconductor elements, which can suppress a deterioration of connection reliability of a mounting portion of the semiconductor elements due to the mounting stress that occurs when the package is mounted to the mother board.

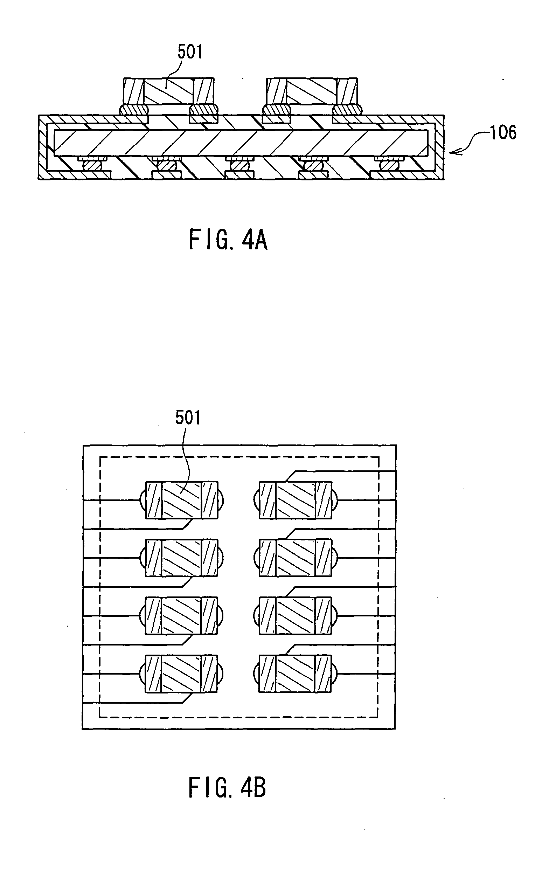

As shown in Fig. 4A, chip components 501 such as a resistor, a capacitor and an inductor may be mounted on the electronic component package 106 of this embodiment. Fig. 4B shows the appearance of the electronic component package of Fig. 4A that is viewed from a side of the chip components. In this way, the chip components are mounted on the electronic component package 106 of this embodiment, so that the chip components can be built up and mounted within an area occupied by the semiconductor elements. Therefore, a packaging density of electronic components can be enhanced. Additionally, the peripheral circuit of the semiconductor elements may be incorporated into the semiconductor package, thus allowing the provision of a functional module constituted by the semiconductor elements and the chip components as an electronic component package.

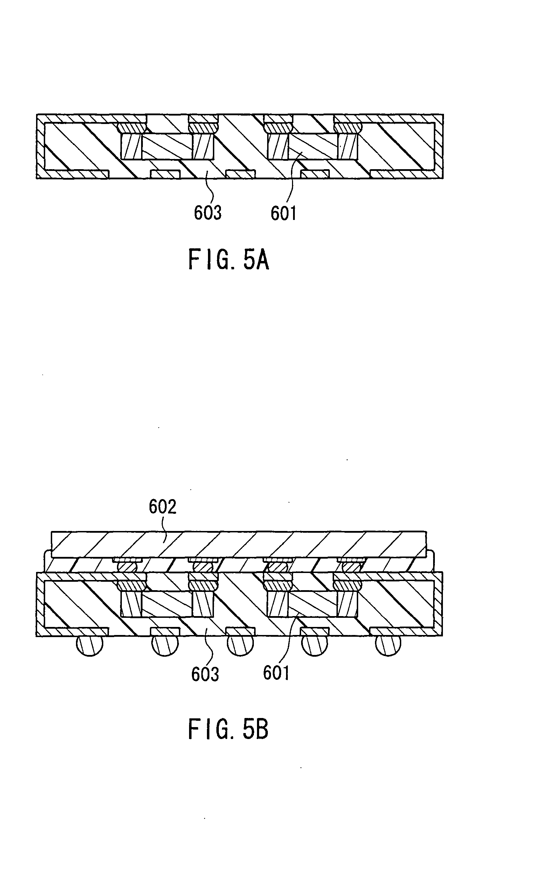

Fig. 5A shows an example where a chip component 601 as an electronic component is arranged within a package. This example has a configuration where a wiring is led out from a mounting face of the chip component to a rear face of the chip component by way of an edge of the package. Fig. 5B shows an example where such a package is used as an interposer of semiconductor. A semiconductor element 602 is bare-chip mounted on the package of Fig. 5A. This configuration allows a capacitor to be arranged directly under a connection terminal of the semiconductor element and allows the stabilization of a power source for the semiconductor element with a thin interposer board, thus realizing a high-speed operation by the semiconductor element.

Herein, the chip components incorporated into the inside of the package are not limited to a capacitor, and a peripheral circuit such as a filter circuit that includes the combination of a capacitor and an inductor may be configured. When such an interposer board is configured, it is preferable that a filler is dispersed in a resin portion 603 so that a thermal expansion coefficient of that portion is adjusted to a value between those of the semiconductor element and the mother board, so as to alleviate a stress caused by a difference in thermal expansion coefficient between the semiconductor element 602 and the mother board.

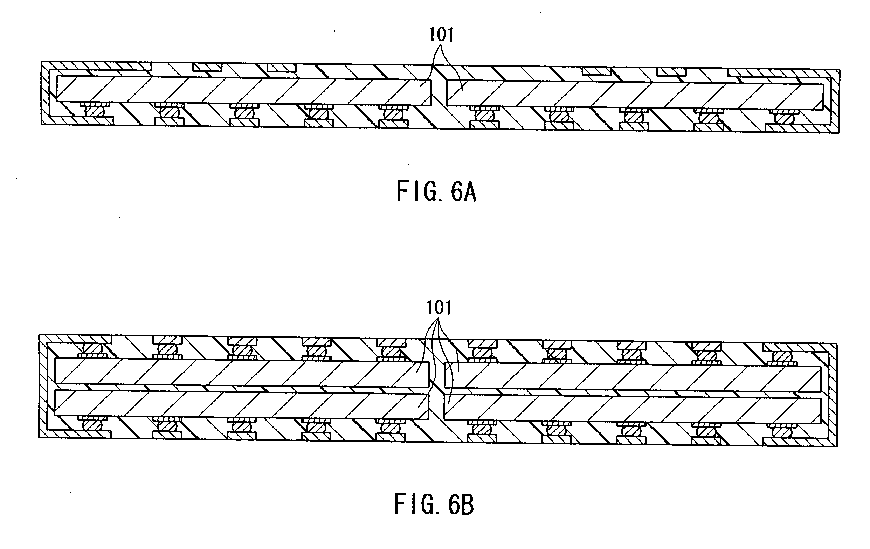

Furthermore, as shown in Figs. 6A to B, a plurality of semiconductor elements 101 may be mounted within the package. Fig. 6A shows an example where two semiconductor elements 101 are mounted, and Fig. 6B shows another example where four semiconductor elements 101 are built up within the package. According to this embodiment, the semiconductor elements are built up within the package, so that a low-profile package in which functions are modularized with a plurality of semiconductor elements can be provided.

The following describes a method for manufacturing the electronic component package of the present invention. Although the following description shows an example where a semiconductor element is mounted as an electronic component, a package of a wide variety of electronic components can be manufactured by replacing the semiconductor element with an electronic component such as a resistor, a capacitor and an inductor.

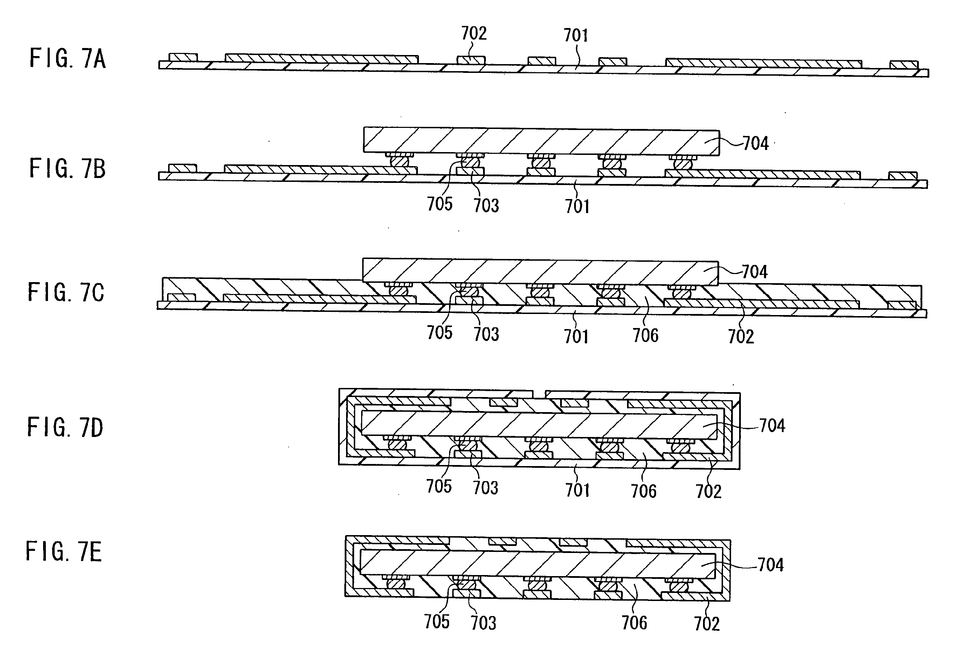

Figs. 7A to E are cross-sectional views showing main manufacturing steps of the electronic component package of the present invention.

As shown in Fig. 7A, a wiring 702 with a desired pattern is formed on a supporting member 701. As the supporting member 701, when a resin sheet is employed for example, a heat-resistant resin such as polyimide, a fluorine based resin or a heat-resistant epoxy resin can be used, and when a metal sheet is employed, aluminum, copper, stainless steel or the like can be used. As the wiring 702, metal foil such as copper foil can be used, and a thickness of the wiring is preferably from about 5 µm to 35 µm. When the wiring is formed by etching so as to form a fine wiring, thin copper foil is used normally. Furthermore, when the flexibility is required for the wiring, the wiring with a tensile strength not less than 400 N/mm² preferably is used. Moreover, the wiring can be formed on the supporting member by plating. When pattern plating of copper is used, a wiring with a width of about 10 µm and a thickness of about 10 µm can be formed. When a thickness of the supporting member 701 is made not more than 100 µm, the folding processing, which will be conducted later, can be performed easily. Next, a semiconductor element 704 is bare-chip mounted on a connection terminal 703 that is formed as this wiring 702, which results in a state shown in Fig. 7B. This drawing shows an example where flip chip mounting is conducted using a solder bump 705. Next, as shown in Fig. 7C, a resin 706 is filled among the semiconductor element 704, the wiring 702 and the supporting member 701 as an encapsulating resin. During this step, the resin 706 is applied so as to extend to a region where the semiconductor element 704 is not mounted. Next, as shown in Fig. 7D, the folding processing is carried out by folding the region where the semiconductor element 704 is not mounted so as to cover the semiconductor element 704 with the supporting member with the wiring formed thereon. Then, the resin 706 is heated in this state so as to cure the resin. As this resin 706, a material obtained by dispersing a filler in a thermosetting resin such as epoxy and by adjusting physical properties of the resin such as a thermal expansion coefficient may be used. During this heat curing, preferably, the folded sides of the package are secured to a frame member, and a pressure is applied gently from a top face of the package so as to ensure sufficient penetration of the resin 706 into the inside of the package. During this step, surplus resin 706 is allowed to flow out of the end portion of the package that is not subjected to the folding, whereby voids remaining within the package can be removed. The flowed resin is removed by cutting the outer shape in a later step. Also, as a result of this heat curing, the wiring 702 is bonded to the resin 706. Next, the supporting member 701 that covers the surface of the package is removed, whereby the electronic component package of this embodiment is obtained as shown in Fig. 7E.

As for the process for removing this supporting member 701, different methods may be used depending on materials of the supporting member. In the case where a resin sheet is used as the supporting member so as to enhance a peeling ability between the wiring 702 and the supporting member 701, the supporting member can be peeled off mechanically. In the case where a metal sheet is used as the supporting member so as to bond the wiring 702 and the supporting member 701 metallically, the supporting member 701 can be removed by dissolving it with a chemical agent.

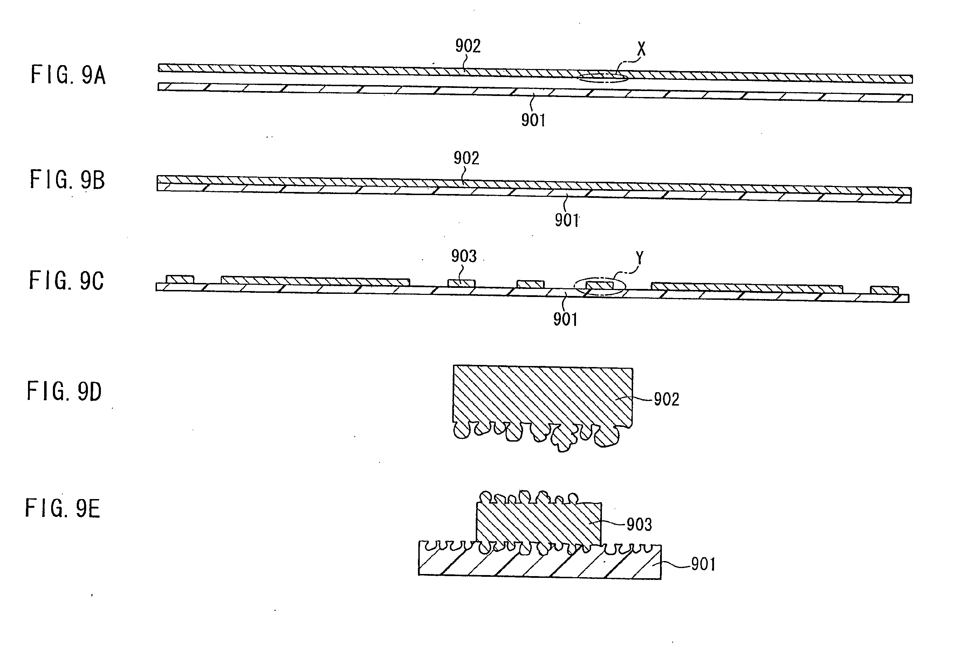

Figs. 9A to E show one example of a manufacturing method by which a wiring is formed on a supporting member. The following is a detailed description of a manufacturing method of a wiring transfer matrix including a supporting member and a wiring.

As a supporting member 901 shown in Fig. 9A, a heat-resistant resin such as polyimide, a fluorine based resin or a heat-resistant epoxy resin may be used. A wiring material 902 is built up and arranged with respect to this supporting member 901. A fine convex configuration is formed at a contacting interface of the wiring material 902 with the supporting member 901. Fig. 9D is an enlarged view of the X part of the surface of the wiring material 902. As the wiring material 902, metal foil such as copper foil can be used, and the fine convex configuration at the surface of the metal foil may be formed by electro plating. By the electro plating, metal in a particle form is deposited on a surface of the metal foil, which is a method having excellent productivity. Preferably, rolled copper foil is used as the metal foil, because of its excellent flexibility. As for the particles deposited by the plating, particles including average particles with a size of about 0.1 µm to 4 µm, inclusive, may be used. If the average particle is larger than 4 µm, a sufficient number of convex shapes between a wiring 903 and the supporting member 901 cannot be obtained when the wiring material 902 is processed into a fine width not more than 20 µm, which results in an insufficient anchor effect and therefore the wiring 903 may fall from the supporting member 901. As for the copper foil having the convex and concave configuration by the particles deposited by the plating shown in Fig. 9D, "DT-GLD" (trade name, produced by Furukawa Circuit Foil Co., Ltd.), for example, is available.

Furthermore, in order to enhance the adhesion properties, Cr, Zn, Ni and a metal oxide of them preferably are formed as an adhesion layer at an interface of this wiring material 902 with the supporting member 901. As the wiring material 902, copper is used generally. Here, copper belongs to a group of materials among metals that has poor adhesion properties with a resin like precious metals such as gold and silver. When the adhesion layer is formed on the surface of the wiring material 902, the adhesion properties with resin of the package also can be improved. As for this wiring material 902, preferably, a fine convex configuration is formed also at a face contacting with the resin of the package in terms of the improvement in adhesion properties.

Next, as shown in Fig. 9B, the supporting member 901 and the wiring material 902 are adhered to each other closely by heating under pressure. During this heating under pressure, the fine convex configuration at the surface of the wiring material 902 is transferred and formed on a surface of the supporting member 901 as a concave configuration, while the wiring material is held by the supporting member by the anchor effect.

When a thermoplastic resin is used as the supporting member 901, the resin is softened and is subjected to plastic deformation during the heating under pressure. In this case, it is preferable that the heat and the pressure are applied as relatively high temperatures and pressures within the bounds of not degrading the resin, and, preferably, this process is carried out in an atmosphere of inert gas or in a vacuum atmosphere so as to avoid the oxidation of the wiring material made of metal.

When a thermosetting resin is used as the supporting member 901, the thermosetting resin is softened during the heating under pressure so as to reduce the viscosity, resulting in the embedment of the fine convex configuration of the surface of the wiring material 902. When the thermosetting resin is used as the supporting member 901, there is a need to give special attention to the compatibility with the resin material of the package to which the wiring is to be transferred. For example, in a state where an epoxy resin used as the supporting member 901 is not cured sufficiently, if the wiring is transferred onto the resin of the package that contains a similar kind of epoxy resin, heat applied during the wiring transfer causes the mixture of the resin of the package with the resin of the supporting member 901, thus making it impossible to transfer and form the wiring.

Next, the wiring material 902 is patterned into the wiring 903 by etching, whereby the state shown in Fig. 9C is obtained. Fig. 9E is an enlarged view of a wiring part Y (Fig. 9C), where a fine concave configuration is formed on a surface of the supporting member 901 and the wiring 903 is held by the supporting member 901.

Furthermore, in order to enhance release properties from the wiring material 902 and the resin material to which the wiring is to be transferred, a releasing treatment preferably is conducted using silicone or the like on the surface of the supporting member 901. When a fluorine based resin is used as the supporting member 901, releasing properties from the resin become excellent and the resin will not be decomposed due to the heat applied during the transferring because of its excellent heat-resistance properties. In addition, since such a resin does not have compatibility with the resin of the package, there is no need of giving a releasing treatment to the surface of the supporting member, and therefore the supporting member can be provided with a reduced number of constituting materials.

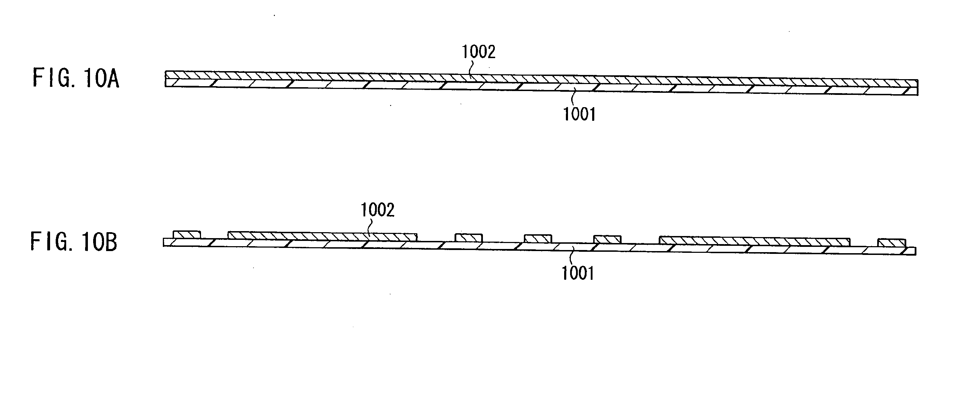

Fig. 10 shows another manufacturing method for forming a wiring on a supporting member. The followings are detailed descriptions of the manufacturing method of a wiring transfer matrix including a supporting member and a wiring, with reference to the drawings.

Fig. 10A shows a composite material in which a wiring material 1002 is held by a supporting member 1001. As the wiring material 1002, copper may be used, which can be formed by electroplating on the supporting member 1001 made of metal foil. Although aluminum and the like can be used as the metal foil, there are some cases where it is difficult to deposit copper directly thereon depending on the materials used for the metal foil. For example, in the case where copper is deposited on aluminum by electroplating, a thin zinc layer is formed generally as an intermediate layer. Additionally, it is preferable to use foil with a flat surface as the metal foil, so as to conduct the electroplating uniformly. The thus formed composite material is a material in which the wiring material 1002 and the supporting member 1001 are metallically bonded to each other closely and firmly.

Next, patterning is conducted on the wiring material 1002 by etching, whereby a state shown in Fig. 10B is obtained. As a material of the supporting member 1001, a material that is not eroded by an etchant during this etching or a material with a reduced etching rate compared to the wiring material should be selected. When a sulfuric acid based etchant is selected and aluminum foil is used as the supporting member, the supporting member is not eroded. This aluminum foil can be removed easily by a hydrochloric acid or NaOH solution in a supporting member removing step.

With the use of the manufacturing methods of this embodiment, wirings can be formed freely on the surface of the package, and input and output terminals from the electronic components can be arranged on the surface and the rear face of the package. That is to say, the wirings are formed with respect to the electronic components only by way of the resin portion, and therefore the electronic component package can be made slimmer and at the same time further electronic components can be mounted on the package, thus enabling the high-density and low-profile building up and mounting of electronic components.

Herein, as shown in Fig. 7E, the package has a configuration where the wiring 702 is embedded from the surface of the package into the resin 706. In this way, the wiring is embedded in the resin portion, whereby the adhesive strength at the external connection terminal portion can be enhanced, which results in the enhancement in mounting reliability. In addition, since the wiring is embedded, there are no problems occurring such as the wiring being bent and disconnected due to an external force applied during the handling, even at a fine wiring portion with a wiring width of about 25 µm.

Furthermore, Fig. 7C shows the example where the resin filled between the semiconductor element 704 and the wiring 702 and the resin applied at the region where the semiconductor element is not mounted are the same material. However, these resins can be made different from each other.

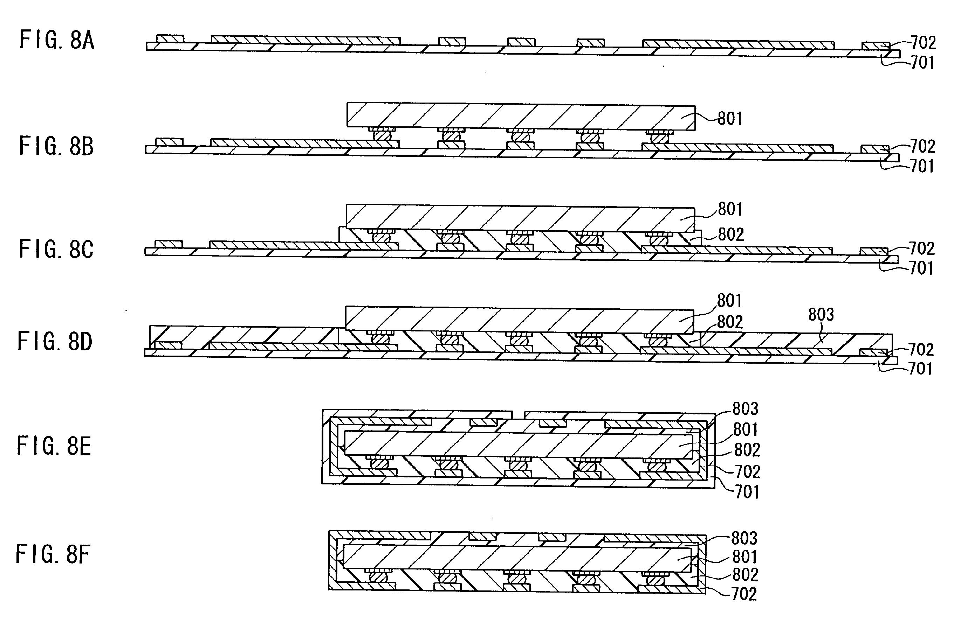

Fig. 8 shows an example where materials with different physical properties are combined as the resin within the package. Explanations of the steps that have been described with reference to Fig. 7 will be omitted. In Fig. 8B, a semiconductor element 801 is bare-chip mounted on a connection terminal that is formed on a supporting member. Next, as shown in Fig. 8C, a resin 802 is filled only at a region where the semiconductor element is mounted. Next, another resin 803 is applied at regions other than the region for mounting the semiconductor element. From this state, the folding processing is carried out similarly to the example shown in Fig. 7, and the resins are subjected to heat curing, whereby a state shown in Fig. 8F is obtained. In Fig. 8F, different resin materials are used on the upper and lower faces of the semiconductor element.

With respect to the external connection terminals that are formed on the surface of the package, different loads may be generated depending on physical properties such as the rigidity and the thermal expansion coefficient of the member that is connected therewith. As shown in Fig. 8F, different materials are combined as the resin within the package so that a material with a low elastic modulus is employed at a portion connected with a member having a substantially different thermal expansion coefficient from that of the semiconductor element so as to function as an elastomer. Thus, the mounting reliability of the external connection terminal portions can be enhanced.

### Embodiment 2

The following describes another embodiment of the present invention, with reference to the drawings.

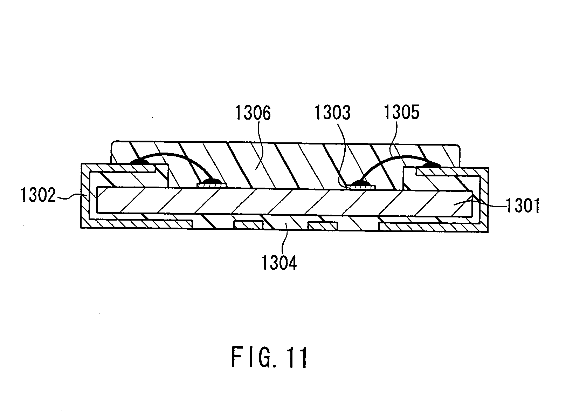

Fig. 11 shows a cross-sectional configuration of an electronic component package of this embodiment. As the electronic component, a semiconductor element 1301 is embedded within the package, and a resin portion 1304 is formed so that a connection terminal 1303 on the semiconductor element is exposed. This connection terminal and a wiring 1302 on the surface of the package are connected electrically via a metal wire 1305. This wiring 1302 is led out from the surface of the package to a rear-face side thereof by way of an edge of the package, so as to be connected with external connection terminals. In addition, a portion where the metal wire is formed is covered with an encapsulating resin 1306 for the purpose of protecting the wire.

The thus configured semiconductor package allows electrical signals to be carried from the active face of the semiconductor element to the rear face only by way of the resin portion, whereby a low-profile semiconductor package can be provided even when bare-chip mounting is employed, using a versatile wire bonding.

Although Fig. 11 shows the example where external connection terminals are not provided on the face of the package to which wire bonding is conducted, external connection terminals may be formed on the outside of the wire-bonding area so as to facilitate the building up of the package.

A method for manufacturing the electronic component package of this embodiment will be described below. The following explains an example where a semiconductor element is mounted as the electronic component. The portions that are the same as in Embodiment 1 will be explained briefly.

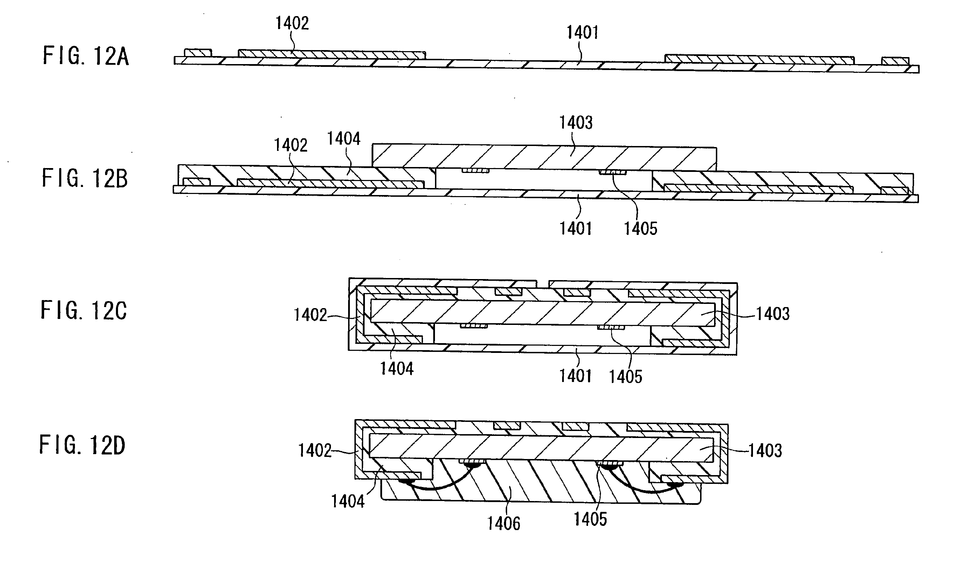

Figs. 12A to D are cross-sectional views showing main manufacturing steps of the electronic component package of this embodiment. As shown in Fig. 12A, a wiring 1402 with a desired pattern is formed on a supporting member 1401. Next, a semiconductor element 1403 is secured on the supporting member by a resin 1404, whereby a state shown in Fig. 12B is obtained. This resin 1404 is formed as shown in Fig. 12B so that a connection terminal 1405 on the semiconductor element 1403 is exposed and the resin is applied at regions other than the region where the semiconductor element is mounted. Next, the supporting member at the regions where the semiconductor element 1403 is not mounted is folded, and the resin 1404 is cured by heating, whereby a state shown in Fig. 12C is obtained. During this step, the flowing properties of the resin should be reduced so as not to flow the resin over the exposed portions of the semiconductor element that are formed in Fig. 12B. Next, the supporting member 1401 is removed, and the connection terminal on the semiconductor element and the wiring on the package are connected electrically by wire bonding. Thereafter, a metal wire portion is encapsulated with an encapsulating resin 1406 so as to protect the metal wire, whereby a state shown in Fig. 12D is obtained.

In this way, the wiring is transferred and formed on the surface of the semiconductor element, whereby a low-profile semiconductor package can be realized even when bare-chip mounting by wire-bonding is employed.

### Embodiment 3

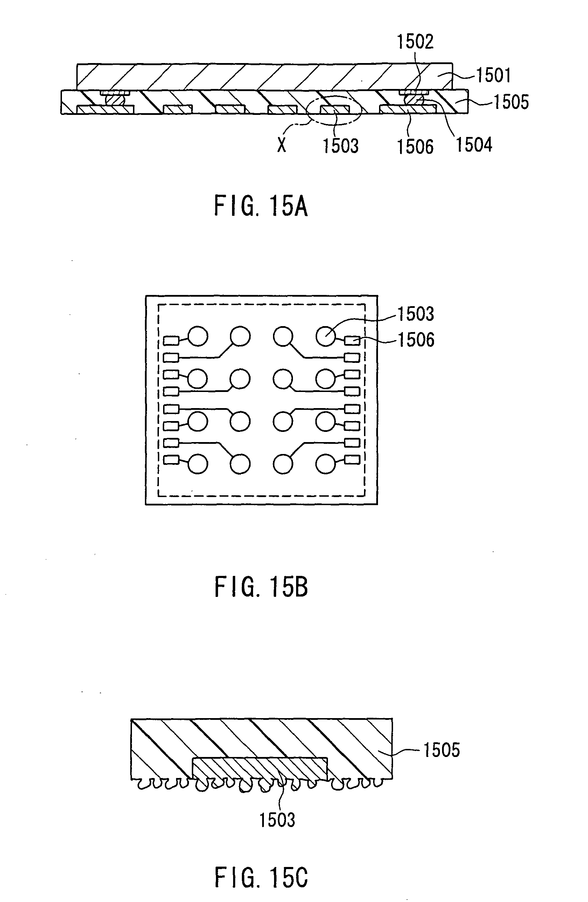

Next, still another embodiment of the present invention will be described below, with reference to the drawings. Fig. 15A is a cross-sectional view showing an electronic component package of this embodiment. A semiconductor element 1501 as the electronic component is mounted via a solder bump 1504 on a connection pad 1506 that is formed with a wiring.

Herein, the method for mounting the semiconductor element is not limited to this, and mounting methods such as ACF and wire bonding can be used similarly to the examples that have been described with reference to Embodiment 1. According to the wire bonding method, the semiconductor element can be mounted by a simper mounting method, and therefore a package can be provided at a low cost. Furthermore, although the example of handling a bare chip as the semiconductor element is described here, this electronic component may be a semiconductor package or a chip component such as a passive component. In this way, the passive component is mounted as well as the semiconductor element, whereby a functional module that incorporates a peripheral circuit can be formed with a package.

The connection pad 1506 that is formed with the wiring is connected electrically with an external connection terminal 1503. This wiring is bonded to the semiconductor element 1501 by a resin portion 1505. Herein, Fig. 15B shows the package of this embodiment that is viewed from a side of the external connection terminal. As shown in Fig. 15B, the connection pad 1506 to which the semiconductor element 1501 is mounted is led out to the external connection terminal 1503. In this way, the external connection terminal 1503 and the connection pad 1506 are arranged separately. Thus a mounting stress, which occurs during the mounting of the electronic component package to a mother board or the like, can be prevented from being applied directly to a mounting portion of the semiconductor element, enhancing the mounting reliability of the electronic component package.

Fig. 15C is an enlarged view of a portion X of the external connection terminal 1503. The external connection terminal 1503 is embedded in the resin portion 1505. Such an embedding configuration enables the firmly bonding of the wiring 1503 to the resin portion 1505. An adhesion treatment such as a treatment for increasing roughness, a metal treatment and an organic treatment may be conducted to a side face portion of the thus embedded external connection terminal 1503, which can further enhance the adhesion properties.

Furthermore, as shown in Fig. 15C, the surface roughness of the outer surface of the external connection terminal 1503 is made larger than that of the connecting face of the external connection terminal 1503. In this way, it is preferable that the degree of the surface roughness of the wirings constituting the external connection terminal 1503 and the connection pad 1506 is not increased on a side of mounting the semiconductor element so as to realize the fine electrical connection with the semiconductor element. When a semiconductor element with a fine terminal is mounted, the uniformity of height in a plane of the external connection terminal to be connected therewith becomes important. Although a required level of the uniformity of height is different depending on mounting methods, a flatness is required increasingly for every method as a connection terminal becomes finer.

On the other hand, as for a portion of the external connection terminal 1503, when the package is mounted to a mother board or the like, a larger mounting stress occurs than in the connection pad 1506. That is to say, the adhesion properties of an electrical connection portion connecting the mother board and the package (e.g., solder, conductive paste) with the external connection terminal 1503 should be secured sufficiently. Thus, as shown in Fig. 15C, the roughness of the surface of the external connection terminal 1503 is increased, whereby the above-described adhesion properties with the electrical connection portion can be enhanced further because of the anchor effect.

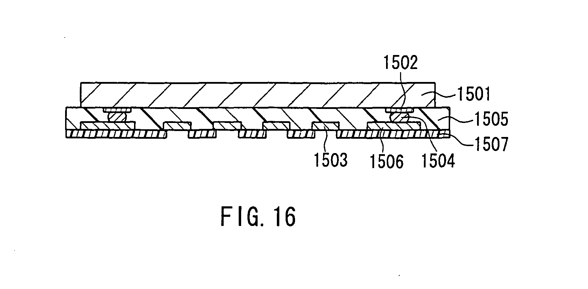

Furthermore, it is preferable that a solder resist 1507 is formed on the surface of the electronic component package of the present invention as shown in Fig. 16. This solder resist 1507 has an effect of suppressing a short with a wiring on the surface of the package, which results from the electrical connection portion (e.g., solder and conductive paste) for mounting the electronic component package to a mother board being widened during the mounting. In addition, in the package of this embodiment, as shown in Fig. 15C, the roughness of the surfaces of both of the resin portion 1505 and the external connection terminal 1503 is increased. That is to say, such increased roughness can enhance the adhesion properties with the solder resist 1507 formed on the surface. As shown in Fig. 16, the periphery of the external connection terminal 1503 is covered with the solder resist 1507, whereby the external connection terminal can be held firmly to the resin portion. Then, since the roughness of the surface of the external connection terminal 1503 is increased as shown in Fig. 15C, the adhesion with the solder resist is further enhanced at the portion covering the periphery, and the holding force of the external connection terminal to the package can be secured. This means that the reliability of the package against the mounting stress can be enhanced.

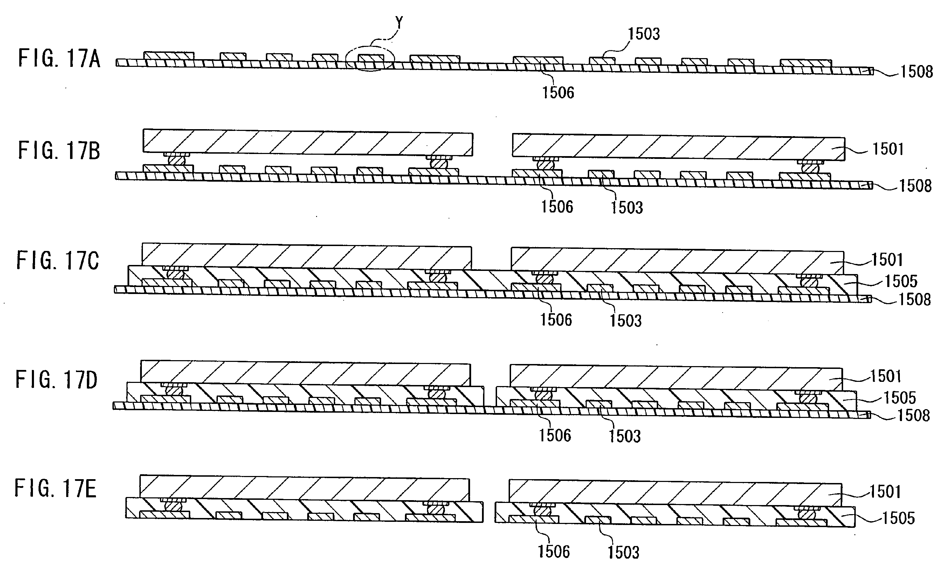

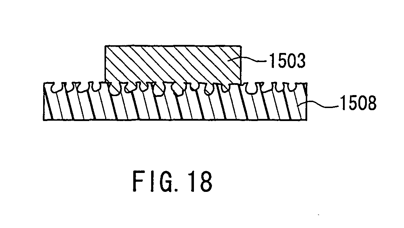

Next, a method for manufacturing the package of the present invention will be described below, with reference to Figs. 17A to E. Note here that explanations on the portions that are the same as in Embodiment 1 will be omitted. Fig. 17A, for example, shows a state where the external connection terminal 1503 is formed as a wiring on a supporting member 1508, which is a configuration similar to that of the example shown in Fig. 9C. Herein, Fig. 18 is an enlarged view of a Y portion of Fig. 17A. This drawing shows a state where the external connection terminal 1503 is held on the supporting member 1508 because of the anchor effect resulting from the increased surface roughness.

Next, as shown in Fig. 17B, a semiconductor element 1501 is mounted by solder on the connection pad 1506. The mounting method herein does not limit the present invention also, as was true for the examples that have been explained as above. Next, a resin portion 1505 is formed between the semiconductor element 1501 and the supporting member 1508, as seen in Fig. 17C. When a mounting method such as ACF is employed, this resin is formed prior to the mounting. Preferably, the resin portion 1505 contains inorganic fillers such as silica and alumina so as to control physical properties such as a thermal expansion coefficient, because this can enhance the mounting reliability.

Furthermore, it is preferable that a thermosetting resin such as polyimide and epoxy is used as a main material of this resin portion, because this can ensure the adhesion force of the resin. This resin portion may be cured under different heating conditions depending on the mounting methods used. Herein, when a resin film having a UV penetrability is used as the supporting member 1508 and a UV curable resin is used as the resin portion, the resin may be cured with ultraviolet irradiation from the rear face of the supporting member.

Next, as shown in Fig. 17D, a groove is formed in the cured resin portion 1505 by dicing or the like. It is preferable to keep this state so as not to cut the supporting member 1508 completely, because this can enhance the workability in the later step of dividing it into individual pieces. Subsequently, as shown in Fig. 17E, the supporting member 1508 is removed, whereby the package of this embodiment can be formed. Herein, as in the case of the above-described examples, different methods can be used for the method for removing the supporting member 1508 depending on materials of the supporting member.

## Claims

1. An electronic component package, comprising:
at least one electronic component;
a wiring provided with a terminal portion with which the electronic component is connected electrically; and
a resin portion that covers at least a part of the electronic component and is for bonding the wiring to the electronic component,
wherein a part of the wiring on a surface of the package extends by way of an edge of the package so as to be formed on a surface and a rear face of the package.

2. The electronic component package according to claim 1, further comprising external connection terminals on the surface and the rear face of the package.

3. The electronic component package according to claim 1, wherein the electronic component is a semiconductor element that is bare-chip mounted in a face-down manner with respect to the wiring.

4. The electronic component package according to claim 1,
wherein the electronic component is a semiconductor element, and
a terminal portion of the semiconductor element exposed from the resin portion is connected electrically with the terminal portion of the wiring by wire bonding.

5. The electronic component package according to claim 1,
wherein the electronic component is a semiconductor element, and
a plurality of the semiconductor elements are built up and arranged within the package.

6. The electronic component package according to claim 1, wherein the electronic component comprises at least one passive component that is selected from the group consisting of a resistor, a capacitor and an inductor.

7. The electronic component package according to claim 1, wherein the wiring is embedded in the resin portion.

8. The electronic component package according to claim 1, wherein the resin portion provided in the package comprises different materials that are built up within the package in a direction of a thickness of the package.

9. The electronic component package according to claim 1, wherein a plurality of layers of the packages are formed.

10. The electronic component package according to claim 1,
wherein a roughness of the wiring made of metal is larger at an outer surface than at a bonding face, and
a convex and concave of the outer surface is formed by metal particles.

11. The electronic component package according to claim 1, wherein a ten point height of irregularities (Rz) of an outer surface of the wiring made of metal ranges from 0.1 µm to 4 µm, inclusive.

12. The electronic component package according to claim 1, wherein the wiring made of metal is formed by transferring.

13. The electronic component package according to claim 1, wherein a pattern transferred from a convex and concave on an outer surface of the wiring made of metal is formed at a resin face of the package that is on the periphery of the metal wiring.

14. A method for manufacturing an electronic component package, comprising:
forming a wiring on a supporting member;
mounting an electronic component on a terminal portion of the wiring;
folding the supporting member with the wiring formed thereon so that the supporting member covers at least a part of the electronic component, while forming a resin portion in a space between the supporting member and the electronic component;
bonding the wiring so as to assemble the package; and
removing the supporting member.

15. The method for manufacturing an electronic component package according to claim 14,
wherein the supporting member is formed with resin, and
the wiring is held on the supporting member with a plurality of convex and concave shapes that are provided at an interface between the wiring and the supporting member,
wherein in the step of removing the supporting member, the supporting member is peeled off mechanically.

16. The method for manufacturing an electronic component package according to claim 14,
wherein the supporting member is formed with metal, and
in the step of removing the supporting member, the metal of the supporting member is dissolved.

17. An electronic component package, comprising:
at least one electronic component; and
a metal wiring that is connected to the electronic component electrically,
wherein the electronic component and at least one face of the metal wiring are bonded to a resin so as to be integrated,
wherein a roughness of the metal wiring is larger at an outer surface than at a bonding face, and
a convex and concave structure of the outer surface is formed by metal particles.

18. The electronic component package according to claim 17, wherein a ten point height of irregularities (Rz) of the outer surface of the metal wiring ranges from 0.1 µm to 4 µm, inclusive.

19. The electronic component package according to claim 17, wherein the metal wiring is formed by transferring.

20. The electronic component package according to claim 17, wherein a pattern transferred from a convex and concave on the outer surface of the metal wiring is formed at a resin face of the package that is on the periphery of the metal wiring.

21. The electronic component package according to claim 17, wherein the electronic component is a semiconductor element that is bare-chip mounted in a face-down manner with respect to the wiring.

22. The electronic component package according to claim 17,
wherein the electronic component is a semiconductor element, and
a terminal portion of the semiconductor element exposed from the resin portion is connected electrically with a terminal portion of the wiring by wire bonding.

23. The electronic component package according to claim 17, wherein the electronic component comprises at least one passive component that is selected from the group consisting of a resistor, a capacitor and an inductor.

24. The electronic component package according to claim 17, wherein the wiring is embedded in the resin portion.
